# EUROPEAN PATENT SPECIFICATION

(11) **EP 1 855 120 B1**
(45) Date of publication and mention of the grant of the patent: **29.05.2013**
(21) Application number: 07105512.3
(22) Date of filing: 03.04.2007
(51) Int. Cl.: G01R 19/25, G01R 31/40

(54) **Device for evaluating line tests of power lines**
Vorrichtung zum Auswerten von Leitungsprüfungen von Hochspannungsleitungen
Dispositif pour évaluer des essais de lignes électriques

(30) Priority: 12.05.2006 SE 0601063
(43) Date of publication of application: 14.11.2007
(73) Proprietor: Balfour Beatty PLC, London SW1V 1LQ (GB)
(72) Inventor: Henning, Lars, 722 16, Västerås (SE); Urbanek, Ulf, 724 82, Västerås (SE)
(74) Representative: Wihlsson, Joakim Per Magnus

(56) References cited:
- WO-A1-00/74192
- WO-A1-2004/111665
- GB-A- 2 339 620
- US-A- 3 886 409
- US-B1- 6 269 316
- US-B1- 6 292 717
- SY RUEN HUANG ET AL: "A Short Circuit Current Study for the Power Supply System of Taiwan Railway", IEEE TRANSACTIONS ON POWER DELIVERY, IEEE SERVICE CENTER, NEW YORK, NY, US, vol. 16, no. 4, 1 October 2001 (2001-10-01), XP011050102, ISSN: 0885-8977

## Description

### FIELD OF THE INVENTION

The present invention relates to a device for evaluating line tests of an outgoing power line comprising a busbar for feeding an alternating voltage to a contact wire connected to the busbar via a main breaker, and an equipment for test energizing the power line, which test equipment comprises a test resistance connected between the busbar and the contact wire and a test breaker for energizing the test resistance with the alternating voltage from the busbar. Further, the invention relates to a method for evaluating line tests of outgoing power lines.

The invention is for example useful for line tests on power feeder lines for railways, and distribution lines and transmission lines for power supply systems.

### PRIOR ART

A power line comprises the line from a power supply sub station to the consumer of the electric power. Traditionally, before operation of a breaker a test energizing is carried out on outgoing traction power lines, i.e. before power is supplied to the line, in order to decide whether the line is for faultless or short-circuit. Such a test energizing is carried out by connecting a test resistance between a busbar of the power supply sub station and the contact wire during a short period of time. According to the prior art, the equipment for test energizing has a test resistance of about 640 Ohm and a "contactor"/breaker which handles the On-operation and Off-operation of the test resistance. The voltage level during the energizing is, for example, determined by determining the mean value of the voltage during the On-operation of the breaker. Usually, the line is regarded as faultless if the level of the voltage is above approximately 2kV. A disadvantage with this method is that it comprises many moving parts, which have a relatively high fault frequency and is space requiring.

In an alternative design, the current through the resistance is measured during energizing of the resistance. The size of the test resistance varies in dependence on the choice of technical solution. If there is a shortcut, the current time area becomes large. The current through the resistance is measured during the time of energizing, and if the time area (As) of the current exceeds a certain time limit, it is supposed that the line is short-circuit. However, it has appeared that this type of measuring is not enough to judge whether there is a short circuit or not on the line. If an electrical load, such as a resistive load, a capacitive load, or an inductive load, for example a transformer, a locomotive transformer, or an auxiliary power transformer station is connected to the line at the time of the test energizing, this load will also give rise to a current time area of the same level as the current time area that occurs at a short-circuit. This problem exists, for example, in the Swedish railway net, since idling RC-locomotive on the railway yard may cause high inrush currents due to energization of the locomotive transformers.

Sy Ruen Huang in IEEE Transactions on power delivery, IEEE Service Center, New York, NY, US, Vol 16, no 4, discloses a simulation model that can be used for measuring impedance in lines powered with direct current. The test procedure comprises clearing trollies from the rail and removal of a LeBlanc transformer so that no residual voltage is left followed by shorting out the trolly contact wire and the rail at the intended test zone.

US 3,886,409 describes an improved safety mechanism in cable constructions used for transporting direct current to remote places from the source by monitoring resistance of a ground conductor utilizing constant current in a series-connected fail-safe circuit by observing voltage drop between ends of the ground conductor.

### OBJECT AND SUMMARY OF THE INVENTION

The object of the present invention is to provide a device for evaluating line tests of outgoing power lines, which makes it possible to determine with a high degree of certainty whether there is a short-circuit or not on the line.

This object is achieved by the initially mentioned device and is characterizes in that the device is adapted to record the voltage between the contact line and earth during the energizing and based on the recorded voltage determine at least one characteristic for the shape of the voltage curve and based on the determined characteristic determine whether the power line is short-circuit or not.

According to the invention, a device as described in claim 1 is provided. It is decided whether the voltage origins from a short circuit or not based on the shape of the voltage curve between the contact wire and earth at least during the energizing of the test resistance and possibly a time after the energizing. By evaluating the shape of the recorded voltage curve it is possible to distinguished a short circuit from an electrical load connected to the line, such as a transformer.

According to an embodiment of the invention, the device is adapted to determine the characteristics of the voltage curve based on the recorded voltage during a time period which lasts from the point in time when the test resistor was energized to a point in time that is less than a half period of the feeding voltage, and preferably about a quarter of a period of the feeding voltage. If the line is heavy loaded it can be difficult, or even impossible, to decide whether the line is short circuit or not if the time period used is too long, such as several periods of the feeding voltage. Best results have been achieved when the period is about a quarter of a period of the feeding voltage.

According to an embodiment of the invention, the device is adapted to evaluate whether the voltage origins from an no load line, a short circuit, or an electrical load connected to the line based on said characteristic and based thereon determine whether the power line is short circuit or not.

According to an embodiment of the invention, the device is adapted to decide whether the power line is short-circuited or not by comparing said characteristics with one or more limit values set depending on the expected load on the power line and such that it is possible to determine whether the power line is short circuited or just heavy loaded.

According to an embodiment of the invention, the device is adapted to indicate that the voltage supply line is short circuit if the evaluation shows that the power line is short circuit, and to indicate that the power line is OK if the evaluation shows that the voltage origins from an no load line, or an electrical load connected to the line.

Tests have proved that there is a distinct difference between the shapes of the curves in frequency contents as well as voltage time area, for the recorded voltage when the line is short circuit, when an electrical load is connected to the line, and when it is no load on the line.

According to an embodiment of the invention, the characteristic is the voltage time area of the voltage curve, which is determined by the integral of the recorded voltage. The device comprises means for calculating the integral of the recorded voltage and means for comparing the computed integral with a limit value. The limit value is set in dependence on the expected electrical load on the line. The limit value can also be trimmed on the place of installation. The device is adapted to determine whether the voltage origins from the short circuit or from an electrical load connected to the line based on the comparison. By sampling the voltage and computing the voltage integral, it is possible to determine whether the line is short circuit or if it is an electrical load connected to the line.

According to an embodiment of the invention, the characteristic is the frequency contents of the recorded voltage. The device comprises means for determining the frequency contents of the recorded voltage. By sampling the voltage and determining its frequency contents it is possible to decide if the line is short circuit, or it is an electrical load connected to the line. Preferably, a frequency analyze of the voltage curve is carried out and the evaluation is carried out based on the result of the frequency analyze. The frequency analyze can, for example, be carried out by means of a Fast Fourier Transformation (FFT). The evaluation may include that the determined frequencies are compared with a frequency window. It is also advantageous to use a combination of both said methods and thus carry out the evaluation based on the voltage time area as well as the frequency content of the voltage curve. Thus, a more reliable evaluation is achieved.

Another object of the present invention is to provide a method for evaluation of line tests on outgoing traction power lines for railways, which with a high degree of certainty can determine whether there is a short circuit or not on the line.

This object is achieved by a method as defined in claim 10. Such a method comprises recording the voltage between the contact wire and earth during the energizing, determining at least one characteristic for the shape of the voltage curve based on the recorded voltage and based thereon determining whether the power line is short circuit or not.

The invention is particularly useful evaluation of line test on outgoing catenary feeder lines for railways.

### SHORT DESCRIPTION OF THE DRAWINGS

The invention will now be explained more closely by the description of different embodiments of the invention and with reference to the appended drawings.
Figure 1 shows equipment for test energizing of a traction power line according to prior art and a device for evaluating line tests according to the invention.
Figure 2a shows a typical voltage between a contact wire and earth during energizing of the test resistance when the line is short circuit.
Figure 2b shows the current through the test resistance during energizing of the test resistance when the line is short circuit.
Figure 2c shows the feeding voltage during energizing of the test resistance.
Figure 3a shows a typical voltage between a contact wire and earth during energizing of the test resistance when an electrical load, in the form of a transformer, is connected to the line.
Figure 3b shows the current through the test resistance during energizing of the test resistance when a transformer is connected to the line.
Figure 3c shows the feeding voltage during energizing of the test resistance.
Figure 4 shows a block diagram over a device for evaluating line tests according to an embodiment of the invention.

### DETAILED DESCRIPTION OF PREFERRED EMBODIMENTS OF THE INVENTION

In the following an embodiment example for carrying out the invention is described in connection with line tests of railways, but the invention is not limited to railways, it can also be used in other applications, such as power transmission and power distribution in electricity supply networks.

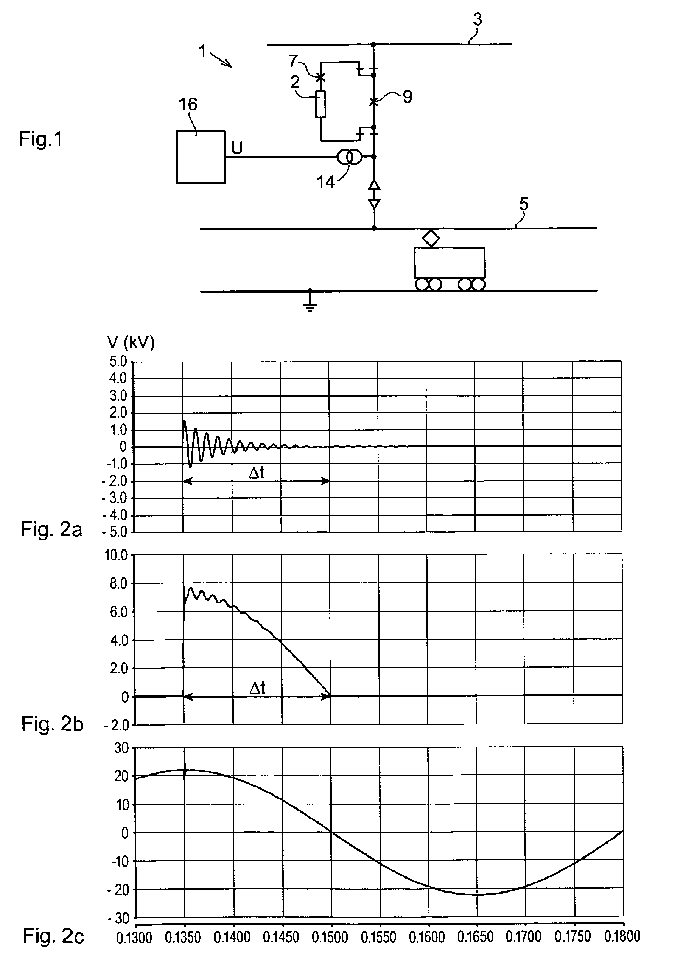

Figure 1 shows test equipment 1 for test energizing of a traction power line according to the prior art. The test equipment 1 comprises a test resistance 2 of for example a few kohm, which is connected between a busbar 3 of a power supply sub station and a contact wire 5, which supplies a traction line with power. The test equipment further comprises a breaker 7 for energizing the test resistance 2. The breaker 7 can be mechanical as well as electronic (static). A demand on the breaker 7 is that it must be possible to control exactly where on the supplied voltage curve it is connected and disconnected. For energizing of the power line 5 a main breaker 9 is arranged between the busbar 3 and the contact wire 5. Before On-operation of power to the line, by means of the main breaker 9, is carried out, a test energizing of the line is usually performed via the test resistance 2. The time period, during which the test resistance is energized, is for example a quarter of a period of the supplied voltage. This test energizing is initiated by a start order signal, which after evaluation by a device according to the invention carries out an On-operation of the main breaker 9.

The figure also shows a voltage transformer 14 arranged to transform the voltage between the contact wire 5 and earth. The transformer 14 is used for measuring the line voltage during normal operation for supervising purpose. For example, it is common in traction networks that this voltage transformer 14 is designed with a transformation factor, which is about 145 times.

Figure 1 shows a device 16 for evaluation of line tests according to an embodiment of the invention. The device 16 can, for example, be connected to existing test equipment 1 on lines where there are problems with transformers that disturb the measuring during the test energizing. In the showed embodiment of the invention, the device 16 and the test equipment 1 are shaped as separate units. In an alternative embodiment, the device 16 and the test equipment 1 can be formed as an integrated unit. The device 16 is connected to the voltage transformer 14. The device 16 is thus receiving a voltage U corresponding to the voltage between the contact wire and earth.

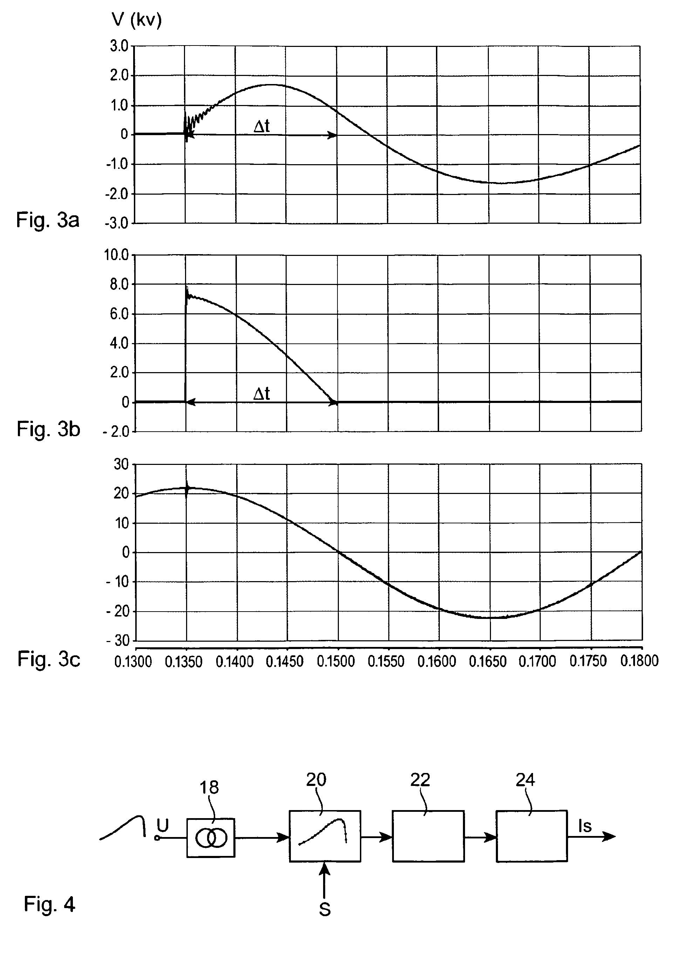

During tests, the shapes of curves on short circuit lines and lines with transformer load have been registered and can, for example, be shaped as shown in figures 2a and 3a. Figure 2a shows a typical voltage between the contact wire and earth during energizing of the test resistance when the line is short circuit, and figure 3a shows a typical voltage between the contact wire and earth at energizing of the test resistance when an electrical load, in the form of a transformer, is connected on the line. Figure 2b shows the current through the test resistance during energizing of the test resistance if the line is short circuit. Figure 2c shows the feeding voltage during energizing of the test resistance. Figure 3b shows the current through the test resistance during energizing of the test resistance when a transformer is connected to the line. Figure 3c shows the feeding voltage during energizing of the test resistance.

The test resistance is energized during a time period Δt, which is the same in both figure 2a-c and 3a-c. From figure 2a it appears that the voltage oscillates with a high frequency about the time axis and the amplitude decreases quickly at a short circuit. From figure 3a it appears that at a transformer connection only a few oscillations occur in the beginning of the time period, where after the voltage increases towards a maximum, in the case showed about 1,5 kV, and is later approaching zero in the end of the time period. A clear difference in frequency and voltage time area between a short circuit and a transformer connection can be seen from the figures. In figure 2a the main contents of the voltage between the contact wire and earth have a high frequency, and the total resulting voltage time area during the time period Δt, with regard to the sign of the voltage, is low, while in figure 3a the main contents of the voltage between the contact wire and earth have low frequency and the total resultant voltage time area during the time period Δt, with regard to the sign of the voltage, is high. By sampling the voltage and computing the voltage integral, a limit value can be chosen, which gives an answer to whether the voltage origins from a short circuit or from a transformer connection. As can be seen from the figures, it is suitable to calculate the voltage integral for the whole period during which the test resistance is energized, or a somewhat longer time period.

The shape of the curve for energizing a no load line is characterized in that it has a very large voltage time area, which for railway applications typically is about 200 Vs and a main frequency contents from about 1,5 times the line frequency and a lower decrease rate, i.e. from about 25 Hz down to about 5 Hz (with decreasing amplitude for lower frequencies).

Figure 4 shows the device 16 in more detail. The device 16 comprises a further voltage transformer 18 adapted to receive the voltage U from the transformer 14 and to transform the voltage U to a few volt. The size of the transformed voltage depends on the electronic used for the subsequent signal treatment. The transformer 18 has a transformer factor in the order of 20-30 times. After the transformer 18, the voltage is in the order of 0-5V. Thereafter the transformed voltage signal is sampled in a sampling device 20, for example, with a sampling frequency of about 2 kHz. By the sampling, the analogue voltage signal is transformed to a digital signal, which is suitable for further signal treatment in a computer. It is a desire that the start order for the sampling is initiated in connection the start of the test energizing of the test equipment. The sampling continues at least during the time period when the test resistance is energized. The sampled voltage signal is transferred to a signal treatment unit 22 adapted to decide at least one characteristic for the shape of the voltage curve, based on the recorded voltage. According to a first embodiment, the signal treatment unit 22 comprises an integral calculator, which calculates the integral of the sample voltage over the time Δt during which the test resistance has been energized, or possibly during a somewhat longer time period. According to a second embodiment of the invention, the signal treatment unit 22 comprises a frequency analyzer, for example a FFT-analyzer, which analyzes the frequency contents of the voltage curve over the time Δt during which the test resistance has been energized, or possibly during a somewhat longer time period. According to a third embodiment of the invention, the signal treatment unit 22 comprises an integral calculator as well as a frequency analyzer.

Thereafter, the determined characteristic is transferred to an evaluation unit 24, which based on the determined characteristic evaluates whether the voltage origins from a short circuit or an electrical load connected to the line. If the integral of the voltage curve has been calculated, the calculated integral is compared with a limit value for the voltage time area. If the calculated integral is larger than the limit value, the voltage is considered to originate from a load connection or from a no load line, and if the calculated integral is less than the limit value, the voltage is considered to origin from a short circuit.

In this embodiment, the evaluation unit 24 is arranged to evaluate whether the voltage origins from a no load line or not based on the determined characteristic and based thereon determines whether the power line is short circuit or not. Since the voltage time area is essentially larger for a no load line than for short circuit line, no extra steps are needed to determine whether the line is short circuit or not, when the determined characteristic is the integral. It is enough to determine whether the integral is larger than the limit value or not to be able to determine whether the power line is short circuit or not. If the determined characteristic is the frequency it might be necessary with another step in the evaluation to determine if the voltage origins from an idling load or not. If the voltage origins from an idling load, the line is not short circuit.

If one or more of the frequencies of the voltage curve has been calculated, the calculated frequencies are compared with a limit value based on the expected frequency spectra for a short circuit, for a faultless, or unloaded line, respectively. For example, if the main part of calculated frequencies is larger than the limit value, the voltage can be considered to origin from a short circuit, and if the main part of the frequencies is lower than the limit value, the voltage can be considered to origin from a load connection.

Thereafter, an indication signal Is is generated, which indicates whether the traction power line is short circuit or not. The indication signal Is is generated based on the evaluation. If the result from the evaluation shows that there is a short circuit, the indication signal Is will indicate that the traction power line is short circuit. If the evaluation shows that the voltage origins from a load connection, or from a no load line, the indication signal Is will indicate that the traction power line is OK.

The device 16 comprises necessary hardware and software for carrying out the above described signal treatment, for example a microprocessor and memory units.

## Claims

1. Device (16) for evaluating line tests of an outgoing power line comprising a busbar (3) for feeding an alternating voltage to a contact wire (5) connected to the busbar (3) via a main breaker (9), and an equipment (1) for test energizing the power line, which test equipment (1) comprises a test resistance (2) connected between the busbar (3) and the contact wire (5) and a test breaker (7) for energizing the test resistance (2) with the alternating voltage from the busbar (3), **characterized in that** the device (16) is adapted to record a voltage (U) between the contact wire (5) and earth during the test energizing and comprises
a voltage transformer (18) adapted to receive and transform the voltage (U) to a few volt,
a sampling device (20) adapted to sample the transformed voltage,
a signal treatment unit (22) adapted to determine at least one characteristic for the shape of the voltage curve, based on the recorded voltage, whereby
the signal treatment unit (22) comprises an integral calculator, which calculates the integral of the sampled voltage over time (Δt) during which the test resistance (2) has been energized and/or
the signal treatment unit (22) comprises a frequency analyzer, which analyzes the frequency contents of the voltage curve over time (Δt) during which the test resistance (2) has been energized, and
an evaluation unit (24), which based on the determined characteristic evaluates whether the voltage origins from a short circuit or an electrical load connected to the line.

2. Device (16) according to claim 1, **characterized in that** said characteristic is the voltage time area of the voltage curve.

3. Device (16) according to claim 1, **characterized in that** said characteristic is the frequency content of the recorded voltage.

4. Device (16) according to claim 1, **characterized in that** the frequency analyzer is a FFT-analyzer.

5. Device (16) according to any one of claims 1 to 4, **characterized in that** the time (Δt) is less than a half period of the feeding voltage.

6. Device (16) according to any one of claims 1 to 5, **characterized in that** the time (Δt) is less than a quarter period of the feeding voltage.

7. Device (16) according to any one of claims 1 to 6, **characterized in that** the voltage (U) after the transformer (18) is 0 to 5 V.

8. Device (16) according to any one of claims 1 to 7, **characterized in that** the device (16) is adapted to decide whether the power line is short-circuited or not by comparing said characteristics with one or more limit values set depending on the expected load on the power line and such that it is possible to determine whether the power line is short circuited or loaded.

9. Device according to any one of claims 1 to 8, **characterized in that** it is adapted to indicate that the power line is short-circuit if said evaluation shows that the power line is short-circuit, and to indicate that the power line is OK if said evaluation shows that the voltage origins from a no load line or an electrical load connected to the line.

10. A method for evaluating line tests of an outgoing power line comprising a power supply sub station (3) feeding an alternating voltage to a contact wire (5), wherein the method comprises energizing a test resistance (2), connected between the power supply sub station (3) and the contact wire (5), with alternating voltage from the power supply sub station (3) during a time period, **characterized in**
recording a voltage (U) between the contact wire (5) and earth during the energizing,
transforming the voltage (U) to a few volt,
sampling the transformed voltage,
treating the sampled voltage to determine at least one characteristic for the shape of the voltage curve, based on the recorded voltage (U), by
calculating the integral of the sampled voltage over time (Δt) during which the test resistance (2) has been energized and/or
analyzing the frequency contents of the voltage curve over time (Δt) during which the test resistance (2) has been energized, and
evatuating, based on the determined characteristic, whether the voltage origins from a short circuit or an electrical load connected to the line.

11. The method according to claim 10, **characterized in** using the device (16) according to any one of claims 1 to 9.

12. The method according to claim 10 or 11, **characterized in that** it is evaluated whether the voltage origins from a no load line, from a short-circuit, or from an electric load connected to the line based on said characteristic and based thereon it is determined whether the power line is short-circuit or not.

13. The method according to any one of the claims 10 to 12, **characterized in that** to determine whether the power line is short-circuited or not, said characteristics is compared with one or more limit values, which are set in dependence on the expected load on the power line, and in such a way that it is possible to determine whether the power line is short circuited or just heavy loaded.

14. The method according to claim 13, **characterized in that** a determined frequency is compared with a frequency window.

15. The method according to any one of the claims 10 to 14, **characterized in that** a signal (Is) is generated, which indicates that the power line is short-circuit if said evaluation shows that the power line is short-circuit and which indicates that the power line is OK if the voltage origins from a no load line or an electric load connected to the line.

16. Use of a device (16) according to any one of the claims 1 to 9 for evaluation of line test on outgoing catenary feeder lines for railways.

## Patentansprüche

1. Vorrichtung (16) zur Auswertung von Leitungstests einer abgehenden Stromleitung, umfassend eine Sammelschiene (3) zur Zuführung einer Wechselspannung zu einem Kontaktkabel (5), welches mit der Sammelschiene (3) durch einen Trennschalter verbunden ist, und eine Testanlage (1) zur Testbeaufschlagung der Stromleitung, wobei die Testanlage (1) einen Restwiderstand (2), welcher zwischen der Sammelschiene (3) und dem Kontaktkabel (5) geschaltet ist, und einen Testtrennschalter (7), der den Testwiderstand (2) mit dem Wechselstrom aus der Sammelschiene (3) beaufschlagt, umfasst, **dadurch gekennzeichnet, dass** die Vorrichtung (16) angepasst ist, um eine Spannung (U) zwischen dem Kontaktkabel (5) und Erde während der Testbeaufschlagung abzugreifen, umfassend
einen Spannungstransformator (18), der angepasst ist, um die Spannung (U) aufzunehmen und zu einigen wenigen Volt zu transformieren,
ein Spannungsmessgerät (20), welches angepasst ist, um die transformierte Spannung zu messen,
eine Signalwandlungseinheit (22), welche angepasst ist, um zumindest eine Kenngröße der Form der Spannungskurve zu bestimmen, basierend auf der abgegriffenen Spannung, wobei
die Signalwandlungseinheit (22) einen Integralrechner umfasst, der das Integral der gemessenen Spannung über der Zeit (Δt) berechnet, in der der Testwiderstand (2) beaufschlagt wird, und/oder
die Signalwandlungseinheit (22) einen Frequenzanalysator umfasst, der die Frequenzinhalte der Spannungkurve über der Zeit (Δt) analysiert, in der der Testwiderstand (2) beaufschlagt wird, und
eine Auswerteeinheit (24), weiche basierend auf den bestimmten Kenngrößen auswertet, ob die Spannung aus einem Kurzschluss oder einer mit der Leitung verbundenen elektrischen Last stammt.

2. Vorrichtung (16) nach Anspruch 1, **dadurch gekennzeichnet, dass** die Kenngröße der Spannungszeitbereich der Spannungskurve ist.

3. Vorrichtung (16) nach Anspruch 1, **dadurch gekennzeichnet, dass** die Kenngröße der Frequenzinhalt der aufgezeichneten Spannung ist.

4. Vorrichtung (16) nach Anspruch 1, **dadurch gekennzeichnet, dass** der Frequenzanalysator ein FFT-Analysator ist.

5. Vorrichtung (16) nach einem der Ansprüche 1 bis 4, dadurch gekenntzeichnet, dass die Zeit (Δt) weniger als eine Halbperiode der zugeführten Spannung beiträgt.

6. Vorrichtung (16) nach einem der Ansprüche 1 bis 5, dadurch gekenntzeichnet, dass die Zeit (Δt) weniger als eine Viertelperiode der zugeführten Spannung beträgt.

7. Vorrichtung (16) nach einem der Ansprüche 1 bis 6, dadurch gekennzeichet, dass die Spannung (U) nach dem Transformator (18) 0 bis 5 V beträgt.

8. Vorrichtung (16) nach einem der Ansprüche 1 bis 7, dadurch gekenntzeichnet, dass die Vorrichtung zu angepasst ist, um zu entscheiden, ob die Stromleitung kurzgeschlossen ist oder nicht, sie die Kenngröße mit einem oder mehreren Grenzwerten vergleicht, welche abhängig von der erwarteten Last der Stromleitung und derart gesetzt sind, dass es möglich ist, zu bestimmten, ob die Stromleitung kurzgeschlossen ist oder unter Last steht.

9. Vorrichtung nach einem der Ansprüche 1 bis 8, **dadurch gekennzeichnet, dass** sie angepasst ist, um anzuzeigen, dass die Stromleitung kurzgeschlossen ist, falls die Auswertung zeigt, dass die Stromleitung kurzgeschlossen ist, und anzuzeigen, dass die Stromleitung in Ordnung ist, falls die Auswertung zeigt, dass die Spannung aus einer lastfreien Leitung oder einer mit der Leitung verbundenen elektrischen Belastung stammt.

10. Ein Verfahren zu Auswertung von Leitungstests einer abgehenden Stromleitung, umfassend eine Stromversorgungsschaltanlage (3). welche ein Kontaktkabel (5) mit einer Wechselspannung beaufschlagt, wobei das Verfahren die Beaufschlagung eines Testwiderstandes (3), welcher zwischen der Stromversorgungsschaltanlage (3) und dem Kontaktkabel (5) geschaltet ist, mit einer Wechselspannung von der Stromversorgungsschaltanlage (3) während einer Zeitspanne umfasst, **gekennzeichnet durch** Abgreifen einer Spannung (U) zwischen dem Kontaktkabel (5) und der Erde während der Beaufschlagung,
Transformation der Spannung (U) zu einigen wenigen Volt,
Messung der transformierten Spannung,
Wandlung der gemessenen Spannung, um zumindest eine Kenngröße für die Form der Spannungskurve zu bestimmen, basierend auf der abgegriffenen Spannung (U), **durch**
Berechnung des Integrals der gemessenen Spannung über die Zeit (Δt), in der der Testwiderstand (2) beaufschlagt wird, und/oder
Analysierund des Frequenzinhaltes der Spannungskurve über der Zeit (Δt), in der der Testwiderstand (2) beaufschlagt wird, und
Auswertung, basierend auf der bestimmten Kenngröße, ob die Spannung aus einem Kurzschluss oder einer mit der Leitung verbundenen elektrischen Belastung stammt.

11. Das Verfahren nach Anspruch 10, **dadurch gekennzeichnet, dass** die Vorrichtung (16) nach einem der Ansprüche 1 bis 9 verwendet wird.

12. Das Verfahren nach Anspruch 10 oder 11, **dadurch gekennzeichnet**, das ausgewertet wird, ob die Spannung aus einer lastfreien Leitung, aus einem Kurzschluss oder aus einer mit der Leitung verbundenen elektrischen Belastung stammt, basierend auf der Kenngröße und darauf basierend bestimmt wird, ob die Stromleitung kurzgeschlossen ist oder nicht.

13. Das Verfahren nach einem der Ansprüche 10 bis 12, dadurch gekennzeichet, dass die Kenngröße mit einem oder mehreren Grenzwerten verglichen wird, welche in Abhängigkeit der erwarteten Last an der Stromleitung und derart gesetzt sind, dass es möglich ist zu bestimmen, ob die Stromleitung kurzgeschlossen oder lediglich hochlastig ist, um zu entscheiden, ob die Stromleitung kurzgeschlossen ist oder nicht.

14. Das Verfahren nach Anspruch 13, **dadurch gekennzeichnet, dass** eine bestimmte Frequenz mit einem Frequenzintervall verglichen wird.

15. Das Verfahren nach einem der Ansprüche 10 bis 14, **dadurch gekennzeichnet, dass** ein Signal (Is) generiert wird, welches anzeigt, dass die Stromleitung kurzgeschlossen ist, falls die Auswertung zeigt, dass die Stromleitung kurzgeschlossen ist, und welches anzeigt, dass die Stromleitung in Ordnung ist, falls die Spannung aus einer lastfreien Leitung oder einer mit der Leitung verbundenen elektrischen Last stammt.

16. Die Verwendung einer Vorrichtung (16) nach einem der Ansprüche 1 bis 9 für die Auswertung eines Leitungstestes an abgehenden Fahrleitungen für Bahnlinien.

## Revendications

1. Dispositif (16) pour évaluer les essais de ligne d'une ligne électrique de sortie comprenant une barre bus (3) pour fournir une tension alternative à un fil de contact (5) connecté à la barre bus (3) par le biais d'un disjoncteur principal (9), et un équipement (1) pour excitation d'essai de la ligne électrique, lequel équipement d'essai (1) comprend une résistance d'essai (2) connectée entre la barre bus (3) et le fil de contact (5) et un disjoncteur d'essai (7) pour exciter la résistance d'essai (2) avec la tension alternative provenant de la barre bus (3), **caractérisé en ce que** le dispositif (16) est conçu pour enregistrer une tension (U) entre le fil de contact (5) et la terre lors de l'excitation d'essai et comprend
un transformateur de tension zu conçu pour recevoir et transformer la tension (U) à quelques volts,
un dispositif d'échantillonnage (20) conçu pour échantillonner la tension transformée,
une unité de traitement de signal (22) conçue pour déterminer au moins une caractéristique pour la formé de la courbe de tension, sur la base de la tension enregistrée, dans lequel
l'unité de traitement de signal (22) comprend un calculateur d'intégrale, qui calcule l'intégrale de la tension échantillonnée au cours du temps (Δt) pendant lequel la résistance d'essai (2) a été excitée et/ou
l'unité de traitement de signal (22) comprend un analyseur de fréquence, qui analyse le contenu de fréquence de la courbe de tension au cours du temps (Δt) pendant lequel la résistance d'essai (2) a été excitée, et
une unité d'évaluation (24), qui sur la base de la caractéristique déterminée évalue si la tension provient d'un court-circuit ou d'une charge électrique connectée à la ligne.

2. Dispositif zu selon la revendication 1, **caractérisé en ce que** ladite caractéristique est la zone temps-tension de la courbe de tension.

3. Dispositif (16) selon la revendication 1, **caractérisé en ce que** ladite caractéristique est le contenu de fréquence de la tension enregistrée.

4. Dispositif (16) selon la revendication 1, **caractérisé en ce que** l'analyseur de fréquence est un analyseur à FFT.

5. Dispositif (16) selon l'une quelconque des revendications 1 à 4, **caractérisé en ce que** le temps (Δt) est inférieur à une demi-période de la tension d'alimentation.

6. Dispositif (16) selon l'une quelconque des revendications 1 à 5, **caractérisé en ce que** le temps (Δt) est inférieur à un quart de période de la tension d'alimentation.

7. Dispositif (16) selon l'une quelconque des revendications 1 à 6, **caractérisé en ce que** la tension (U) après le transformateur (18) est de 0 à 5 V.

8. Dispositif (16) selon l'une quelconque des revendications 1 à 7, **caractérisé en ce que** le dispositif (16) est conçu pour décider si la ligne électrique est court-circuitée ou non en comparant lesdites caractéristiques à une ou plusieurs valeurs limites définies en fonction de la charge attendue sur la ligne électrique et de telle sorte qu'il soit possible de déterminer si la ligne électrique est court-circuitée ou chargée.

9. Dispositif (16) selon l'une quelconque des revendications 1 à 8, **caractérisé en ce qu'**il est conçu pour indiquer que la ligne électrique est en court-circuit si ladite évaluation montre que la ligne électrique est en court-circuit, et pour indiquer que la ligne électrique fonctionne correctement si ladite évaluation montre que la tension provient d'une ligne hors charge ou d'une charge électrique connectée à la ligne.

10. Procédé pour évaluer les essais de ligne d'une ligne électrique de sortie comprenant une sous-station d'alimentation électrique (3) fournissant une tension alternative à un fil de contact (5), le procédé comprenant l'excitation d'une résistance d'essai (2), connectée entre la sous-station d'alimentation électrique (3) et le fil de contact (5), avec une tension alternative provenant de la sous-station d'alimentation électrique (3) au cours d'une période de temps, **caractérisé par**
l'enregistrement d'une tension (U) entre le fil de contact (5) et la terre pendant l'excitation,
la transformation de la tension (U) à quelques volts,
l'échantillonnage de la tension transformés,
le traitement de la tension échantillonnée pour déterminer au moins une caractéristique pour la forme de la courbe de tension, sur la base de la tension enregistrée (U), en
calculant l'intégrale de la tension échantillonnée au cours du temps (Δt) pendant lequel la résistance d'essai (2) a été excitée et/ou
analysant le contenu de fréquence de la courbe de tension au cours du temps (Δt) pendant lequel la résistance d'essai (2) a été excitée, et
évaluant, sur la base de la caractéristique déterminée, si la tension provient d'un court-circuit ou d'une charge électrique connectée la ligne.

11. Procédé selon la revendication 10, **caractérisé par** l'utilisation du dispositif (16) selon l'une quelconque des revendications 1 à 9.

12. Procédé selon la revendication 10 ou 11, **caractérisé en ce qu'**on évalue si la tension provient d'une ligne hors charge, d'un court-circuit ou d'une charge électrique connectée à la ligne sur la base de ladite caractéristique et sur cette base, on détermine si la ligne électrique est en court-circuit ou non.

13. Procédé selon l'une quelconque des revendications 10 à 12, **caractérisé en ce que** pour déterminer si la ligne électrique est court-circuitée ou non, lesdites caractéristiques sont comparées à une ou plusieurs valeurs limites, qui sont définies en fonction de la charge attendue sur la ligne électrique, et de telle marnière qu'il soit possible de déterminer si la ligne électrique est en court-circuit ou simplement fortement chargée.

14. Procédé selon la revendication 13, **caractérisé en ce qu'**une fréquence déterminée est comparée à une fenêtre de fréquence.

15. Procédé selon l'une quelconque des revendications 10 à 14, **caractérisé en ce qu'**un signal (Is) est généré, qui indique que la ligne électrique est en court-circuit si ladite évaluation montre que la ligne électrique est en court-circuit et qui indique que la ligne électrique fonctionne correctement si la tension provient d'une ligne hors charge ou d'une charge électrique connectée à la ligne.

16. Utilisation d'un dispositif (16) selon l'une quelconque des revendications 1 à 9 pour une évaluation d'essai de ligne sur les lignes de départ d'alimentation de caténaires pour chemin de fer.
